# EUROPÄISCHE PATENTSCHRIFT

(11) **EP 3 004 414 B1**
(45) Veröffentlichungstag und Bekanntmachung des Hinweises auf die Patenterteilung: **13.06.2018**
(21) Anmeldenummer: 14730418.2
(22) Anmeldetag: 10.05.2014
(51) Int. Cl.: C23C 14/06, F16J 9/14

(54) **VERFAHREN ZUR HERSTELLUNG EINES KOLBENRINGS**
METHOD FOR PRODUCING A PISTON RING
PROCÉDÉ POUR LA FABRICATION D'UN SEGMENT DE PISTON

(30) Priorität: 04.06.2013 DE 102013009369
(43) Veröffentlichungstag der Anmeldung: 13.04.2016
(73) Patentinhaber: Federal-Mogul Burscheid GmbH, 51399 Burscheid (DE)
(72) Erfinder: LAMMERS, Ralf, 42929 Wermelskirchen (DE); BAUER, Christiane, 51399 Burscheid (DE); IVANOV, Yuriy, 51399 Burscheid (DE)
(74) Vertreter: Döpp, Ludger
(86) Internationale Anmeldenummer: PCT/DE2014/000242
(87) Internationale Veröffentlichungsnummer: WO 2014/194874

(56) Entgegenhaltungen:
- EP-B1- 1 359 351
- DE-A1-102009 052 587
- DE-A1-102010 046 551
- JP-A- 2001 295 699

## Beschreibung

Die Erfindung betrifft ein Verfahren zur Herstellung eines aus Gusseisen oder Stahlguss bestehenden Kolbenrings gemäß gattungsbildendem Teil des ersten Patentanspruchs.

Allgemein bekannt ist, Kolbenringe mit verschleißfesten Schichten zu versehen. Hier werden vielfach sehr harte PVD-Schichten auf der Lauffläche abgeschieden. Aus Motorläufen ist bekannt, dass Kolbenringe, insbesondere der ersten Nut, am Stoß einen höheren Verschleiß als im Ringrücken aufweisen. Gleichzeitig beeinträchtigt die PVD-Schicht die Radialdruckverteilung des Rings im motorischen Betrieb. Aufgrund unterschiedlicher Wärmeausdehnungen der Beschichtungen und des Grundwerkstoffs (Bimetalleffekt) erhöht sich der Druck am Stoß und begünstigt so einen noch höheren Verschleiß in diesem Bereich. Dies führt ebenfalls zu einer höheren Belastung des Gegenkörpers und damit auch zu höherem Verschleiß desselben.

Der JP 2001-295699 A ist ein laufflächenbeschichteter Kolbenring zu entnehmen. Die Lauffläche dieses Kolbenrings ist mit einer harten PVD-Schicht versehen. Auf selbiger wird eine weitere Schicht abgeschieden, die bessere Einlaufeigenschaften als die harte PVD-Schicht hat. Durch diese Maßnahme soll eine optimierte Druckverteilung in Umfangrichtung des Kolbenrings gesehen gegeben sein, da die Einlaufschicht im stoßnahen Bereich des Kolbenrings relativ schnell abgetragen wird.

Die EP 1 359 351 B1 betrifft ein gattungsbildendes Verfahren. Ein mit einem Stoß versehener Grundkörper wird in Rotation versetzt und um eine Verdampfungsquelle herum gedreht. Durch unterschiedliche Rotationsgeschwindigkeiten werden, über den Umfang des Grundkörpers gesehen, unterschiedliche Schichtdicken erzeugt. Die Schichtdicke im Stoßbereich soll hierbei größer sein als im übrigen Umfangsbereich.

Durch die DE 10 2010 046 551 A1 ist ein Verfahren zur Herstellung eines mit einem Stoß versehenen Kolbenrings bekannt geworden, indem ein ringförmiger, metallischer Grundkörper, zumindest im Bereich seiner äußeren Umfangsfläche mit mindestens einer harten Schicht versehen wird, wobei im Anschluss an diese Beschichtung die innere Umfangsfläche des Kolbenrings zumindest partiell in wandstärkenreduzierender Weise durch Materialabtrag bearbeitet wird.

In der DE 10 2009 052 587 A1 wird ein Kolbenring, insbesondere ein Kompressionskolbenring, angesprochen, beinhaltend eine Lauffläche, obere und untere Flankenbereiche, eine innere Umfangsfläche sowie einen Stoß, wobei die Wanddicke des Kolbenrings, über seinen Umfang gesehen, gleich ausgebildet ist und zumindest die Lauffläche mit einer PVD- oder einer CVD-Schicht versehen ist, dergestalt, dass die Laufflächenschicht im stoßnahen Umfangsbereich eine geringere Schichtstärke als im übrigen Umfangsbereich der Lauffläche aufweist.

Aufgrund der unterschiedlichen Wärmeausdehnungskoeffizienten des Kolbenringgrundwerkstoffs und der PVD-Schicht ändert sich die Radialdruckverteilung im Motorbetrieb ab ca. 150 °C Ringtemperatur dahingehend, dass sich ein erhöhter Radialdruck im Stoßbereich ausbildet.

Der Erfindung liegt die Aufgabe zugrunde, die Lebensdauer eines PVDbeschichteten Kolbenrings zu erhöhen, wobei gleichzeitig der Gegenkörper keinem erhöhten Verschleiß, bzw. keiner erhöhten Belastung, ausgesetzt werden soll.

Diese Aufgabe wird dadurch gelöst, dass der Kolbenringgrundkörper so bearbeitet wird, dass er im nicht motorischen kalten Betriebszustand eine Radialdruckverteilung aufweist, bei welcher die Stoßenden über einen definierten Umfangswinkel nahezu keinen Radialdruck aufweisen, dass auf einem Kolbenringgrundkörper mit einem Ausdehnungskoeffizienten < 15 x 10⁻⁶/K im Temperaturbereich zwischen 100 und 200°C eine PVD-Schicht mit einem Ausdehnungskoeffizienten < 4 x 10⁻⁶/K aufgebracht wird und die variable Schichtdicke der PVD-Schicht so eingestellt wird, dass der stoßnahe Bereich des Kolbenringgrundkörpers mit einer Schichtdicke der PVD-Schicht < 100 µm, insbesondere < 60 µm, und der verbleibende Umfangsbereich des Kolbenringgrundkörpers mit einer Schichtdicke der PVD-Schicht < 60 µm, insbesondere < 40 µm, versehen wird, so dass bei einer Kolbenringtemperatur oberhalb von 150°C eine nahezu gleichmäßige Radialdruckverteilung über den gesamten Ringumfang des Kolbenrings, gegeben ist.

Vorteilhafte Weiterbildungen des anmeldungsgemäßen Verfahrens sind den zugehörigen verfahrensgemäßen Unteransprüchen zu entnehmen.

Diese Aufgabe wird auch dadurch gelöst, dass der Kolbenringgrundkörper aus einem Stahl-Werkstoff mit einem Wärmeausdehnungskoeffizienten < 15 x 10⁻⁶/K im Temperaturbereich zwischen 100 und 200°C besteht, dass die PVD-Schicht im stoßnahen Bereich des Kolbenringgrundkörpers, über einen definierten Umfangsbereich gesehen, von ihrer Materialstärke her, dicker als im verbleibenden Umfangsbereich ausgebildet ist, dergestalt, dass die Schichtdicke der PVD-Schicht im stoßnahen Bereich zwischen 40 und 100µm und die Schichtdicke der PVD-Schicht im verbleibenden Umfangsbereich zwischen 5 und 60 µm beträgt.

Vorteilhafte Weiterbildungen dieses Kolbenrings sind den zugehörigen gegenständlichen Unteransprüchen zu entnehmen.

Der mit einem Stoß versehene Kolbenring beinhaltet einen Grundkörper aus Stahlguss oder Gusseisen, auf dessen äußeren Umfangsfläche zumindest eine verschleißfeste PVD-Schicht aufgebracht ist, wobei die PVD-Schicht im stoßnahen Bereich des Kolbenringgrundkörpers, über einen definierten Umfangsbereich gesehen, von ihrer Materialstärke her dicker als im verbleibenden Umfangsbereich ausgebildet ist.

Einem weiteren Gedanken der Erfindung gemäß wird auf einem aus einem Stahlguss-Werkstoff, respektive Gusseisen, bestehenden Kolbenringgrundkörper mit einem Ausdehnungskoeffizienten < 15 x 10⁻⁶/K im Temperaturbereich zwischen 100 und 200°C eine PVD-Schicht mit einem Ausdehnungskoeffizienten < 4 x 10⁻⁶/K aufgebracht.

Vorteilhafterweise wird die Schichtdicke der PVD-Schicht im stoßnahen Bereich zwischen 20 und 40 % stärker als im verbleibenden Umfangsbereich ausgebildet.

Einem weiteren Gedanken der Erfindung gemäß beträgt die Schichtdicke der PVD-Schicht im stoßnahen Bereich zwischen > 40 und 100 µm, und die Schichtdicke der PVD-Schicht im verbleibenden Umfangsbereich zwischen 5 und 60 µm.

Ist die PVD-Schicht als Viellagenschicht (z.B. AlTiN/CrN) oder als homogene Schicht, wie z.B. CrN, CrN(O) oder CrN mit einem Sauerstoffgehalt bis zu 15 Gew.-% ausgebildet, hat sie vorteilhafterweise im Temperaturbereich zwischen 100 und 200°C einen Wärmeausdehnungskoeffizienten < 4 x 10⁻⁶/K, wobei die Schichtdicke der PVD-Schicht im Bereich des Kolbenringrückens zwischen 5 und < 40 µm und im stoßnahen Bereich zwischen 40 und < 100 µm beträgt.

Ist die PVD-Schicht auf Basis von C ausgebildet, hat sie, einem weiteren Gedanken der Erfindung gemäß, im Temperaturbereich zwischen 100 und 200°C einen Wärmeausdehnungskoeffizienten < 2 x 10⁻⁶/K, wobei die Schichtdicke der PVD-Schicht im Bereich des Kolbenringrückens zwischen > 1 und 20 µm und im stoßnahen Bereich max. 30 µm beträgt.

Bedarfsweise kann die PVD-Schicht auch mit Nanopartikeln versehen werden.

Der stoßnahe Bereich wird, einem weiteren Gedanken der Erfindung gemäß, ausgehend vom jeweiligen Stoßende in einem Winkelbereich von 10 bis 40° mit der dickeren PVD-Schicht versehen.

Durch geeignete Prozessführung während des Beschichtungsvorgangs wird über den Umfang des Kolbenringgrundkörpers eine variable Schichtdicke erzeugt. Wie bereits angesprochen, ist die PVD-Verschleißschutzschicht im stoßnahen Bereich deutlich dicker ausgeführt, um hier dem erhöhten Verschleiß zu begegnen und damit die Lebensdauer des so ausgeführten Kolbenrings signifikant zu erhöhen.

Über den Rest des Umfangs, insbesondere im Ringrücken, bleibt die ursprüngliche Schichtdicke erhalten. Dadurch wird die Bimetallwirkung der Schicht nicht verstärkt.

Die Ringform, insbesondere des heißen Kolbenrings, kann im Einsatzfall durch gezielten Schichtaufbau so gesteuert werden, dass die Stoßenden deutlich weniger Druck auf den Gegenkörper, bspw. eine Zylinderlaufbahn ausüben.

Da erfindungsgemäß die Stoßenden des kalten Kolbenrings nahezu keinen Radialdruck entfalten, stellt sich durch den nicht zu unterdrückenden Bimetalleffekt im idealen Anwendungsfall bei einer Kolbenringtemperatur ab 150°C eine gleichmäßige Radialdruckverteilung über den gesamten Ringumfang ein. Durch diese Maßnahme lässt sich auch die Kolbenringform günstig beeinflussen, womit der Druck am Stoß verringert und somit einem erhöhten Verschleiß insbesondere im stoßnahen Bereich entgegengewirkt wird.

Der erfindungsgemäße Kolbenring ist vielfach einsetzbar. So sind Anwendungen in Verbrennungsmotoren von Fahrzeugen (PKW, LKW, Bus), Industrieanwendungen (z.B. Stationärmotoren), Baufahrzeugen, Lokomotiven und Schiffen denkbar. Bevorzugt sind Anwendungen im Bereich von Dieselmotoren, insbesondere Zweitaktgroßdieselmotoren.

Der Erfindungsgegenstand ist anhand eines Ausführungsbeispiels in der Zeichnung dargestellt und wird wie folgt beschrieben. Es zeigen
- Fig. 1: Prinzipskizze eines Kolbenringgrundkörpers mit angedeuteter Radialdruckverteilung
- Fig. 2: Prinzipskizze eines mit einer PVD-Schicht versehenen Kolbenringgrundkörpers gemäß Fig. 1.

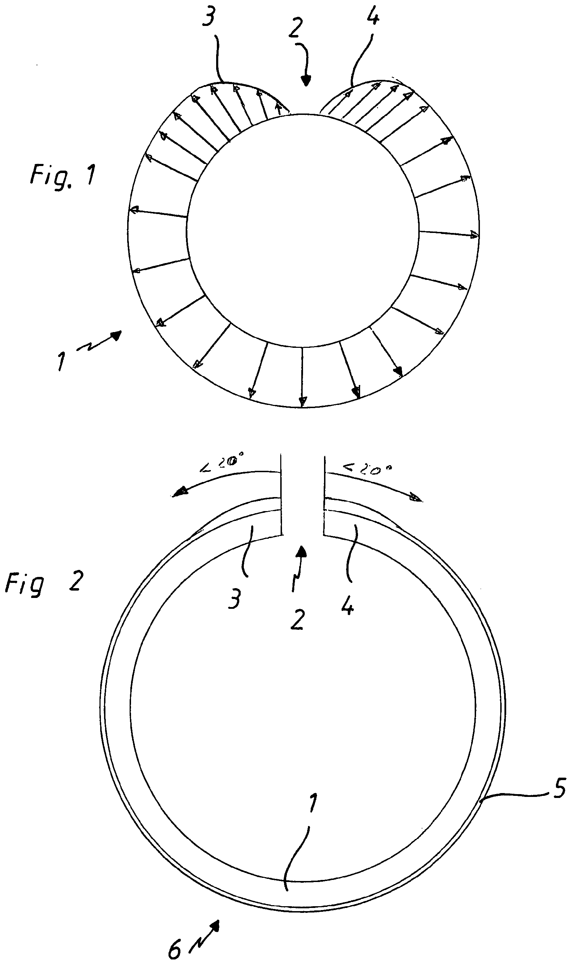

Fig. 1 zeigt einen Kolbenringgrundkörper 1, der mit einem nur angedeuteten Stoß versehen ist. Die Radialdruckverteilung des Kolbenringgrundkörpers 1 in seinem kalten Zustand ist durch Pfeile angedeutet. Erkennbar ist, dass der Kolbenringgrundkörper 1 mit Ausnahme seiner stoßnahen Endbereiche 3, 4 mit etwa der gleichen Radialdruckverteilung, in Umfangsrichtung gesehen, ausgestattet ist. In Richtung der stoßnahen Endbereiche 3, 4, die sich vorzugsweise über einen Umfangswinkel zwischen 10 und 40° erstrecken, soll die Radialdruckverteilung in Bereiche bis nahezu 0 reduziert werden. Dies kann bspw. dadurch herbeigeführt werden, indem der Kolbenringgrundkörper 1 in seinen stoßnahen Endbereichen 3, 4 mit einer Negativkontur versehen wird.

Fig. 2 zeigt den Kolbenringgrundkörper 1 gemäß Fig. 1. Erkennbar ist der Stoß 2 sowie die stoßnahen Endbereiche 3, 4. Der Kolbenringgrundkörper 1 soll in diesem Beispiel aus Stahlguss bestehen und einen Ausdehnungskoeffizienten von 11 x 10⁻⁶/K haben. Auf der die Lauffläche bildenden äußeren Umfangsfläche wird eine PVD-Schicht 5 abgeschieden, die erfindungsgemäß im Bereich der stoßnahen Endbereiche 3, 4 des Kolbenringgrundkörpers 1 eine Schichtdickenerhöhung aufweist. Hierbei können PVD-Viellagenschichten, wie z.B. AlTiN/CrN oder homogene Schichten, wie z.B. CrN mit einem Sauerstoffgehalt bis zu 15 Gew.-% zum Einsatz gelangen. Eine geeignete CrN-PVD-Verschleißschutzschicht hat einen Wärmeausdehnungskoeffizienten von etwa 3 x 10⁻⁶/K. Für derartige CrNbasierte Schichten sind Schichthärten zwischen 800 und 2500 HV alternativ für C-basierte Schichten bis 4500 HV, bedarfsweise auch noch höher, z.B. 6000 HV, erzielbar.

In diesem Beispiel soll die Schichtdicke der PVD-Schicht 5 im Bereich der stoßnahen Endbereiche 3, 4 etwa 42 µm und im Bereich des Ringrückens 6 etwa 15 µm betragen. Infolge des nicht zu unterdrückenden Bimetalleffekts wird der gemäß Fig. 1 vorbereitete Kolbenringgrundkörper 1 im idealen Anwendungsfall ab 150°C Kolbenringtemperatur eine im Wesentlichen gleichmäßige Radialdruckverteilung über den Ringumfang aufweisen.

## Patentansprüche

1. Verfahren zur Herstellung eines aus Gusseisen oder Stahlguss bestehenden Kolbenrings, indem ein Kolbenringgrundkörper (1) erzeugt wird, der, über den Umfang gesehen, mit mindestens einer PVD-Schicht (5) variabler Schichtdicke überzogen wird, dergestalt, dass im Bereich der Stoßenden (3, 4) eine, gegenüber dem verbleibenden Umfangsbereich des Kolbenringgrundkörpers (1), erhöhte Schichtdicke gegeben ist, **dadurch gekennzeichnet, dass** der Kolbenringgrundkörper (1) so bearbeitet wird, dass er im nicht motorischen kalten Betriebszustand eine Radialdruckverteilung aufweist, bei welcher die Stoßenden (3, 4) über einen definierten Umfangswinkel nahezu keinen Radialdruck aufweisen, dass auf einem Kolbenringgrundkörper (1) mit einem Ausdehnungskoeffizienten < 15 x 10⁻⁶/K im Temperaturbereich zwischen 100 und 200°C eine PVD-Schicht (5) mit einem Ausdehnungskoeffizienten < 4 x 10⁻⁶/K aufgebracht wird und die variable Schichtdicke der PVD-Schicht (5) so eingestellt wird, dass der stoßnahe Bereich (3, 4) des Kolbenringgrundkörpers (1) mit einer Schichtdicke der PVD-Schicht (5) < 100 µm, insbesondere < 60 µm, und der verbleibende Umfangsbereich des Kolbenringgrundkörpers (1) mit einer Schichtdicke der PVD-Schicht < 60 µm, insbesondere < 40 µm, versehen wird, so dass bei einer Kolbenringtemperatur oberhalb von 150°C eine nahezu gleichmäßige Radialdruckverteilung über den gesamten Ringumfang des Kolbenrings, gegeben ist.

2. Verfahren nach Anspruch 1, **dadurch gekennzeichnet, dass** die PVD-Schicht (5) als PVD-Viellagenschicht, insbesondere auf Basis von AlTiN/CrN, auf der Lauffläche des Kolbenringgrundkörpers (1) aufgebracht wird.

3. Verfahren nach Anspruch 1, **dadurch gekennzeichnet, dass** die PVD-Schicht (5) als homogene Schicht auf Basis von CrN, CrN(O) oder CrN mit einem Sauerstoffgehalt bis zu 15 Gew.-% auf der Lauffläche des Kolbenringgrundkörpers (1) aufgebracht wird.

4. Verfahren nach Anspruch 1, **dadurch gekennzeichnet, dass** als PVD-Schicht eine C-basierte Schicht eingesetzt wird.

5. Kolbenring hergestellt nach dem Verfahren gemäß einem der Ansprüche 1 bis 4 beinhaltend einen mit einem Stoß (2) versehenen Grundkörper (1) aus Stahlguss oder Gusseisen, auf dessen äußerer Umfangsfläche zumindest eine verschleißfeste PVD-Schicht (5) aufgebracht ist, **dadurch gekennzeichnet, dass** der Kolbenringgrundkörper (1) aus einem Stahl-Werkstoff mit einem Wärmeausdehnungskoeffizienten < 15 x 10⁻⁶/K im Temperaturbereich zwischen 100 und 200°C besteht, dass die PVD-Schicht (5) im stoßnahen Bereich (3, 4) des Kolbenringgrundkörpers (1), über einen definierten Umfangsbereich gesehen, von ihrer Materialstärke her, dicker als im verbleibenden Umfangsbereich ausgebildet ist, dergestalt, dass die Schichtdicke der PVD-Schicht (5) im stoßnahen Bereich (3, 4) zwischen 40 und 100µm und die Schichtdicke der PVD-Schicht (5) im verbleibenden Umfangsbereich zwischen 5 und 60 µm beträgt.

6. Kolbenring nach Anspruch 5, **dadurch gekennzeichnet, dass** die Schichtdicke der PVD-Schicht (5) im stoßnahen Bereich (3, 4) zwischen 20 und 40 % dicker als im verbleibenden Umfangsbereich ausgebildet ist.

7. Kolbenring nach einem der Ansprüche 5 oder 6, **dadurch gekennzeichnet, dass** der Bereich der erhöhten Schichtdicke der PVD-Schicht (5) sich über einen Umfangsbereich zwischen 10 und 40°, insbesondere zwischen 10 und 20°, ausgehend vom Stoß (2) des Kolbenringgrundkörpers (1), erstreckt.

8. Kolbenring nach einem der Ansprüche 6 bis 7, **dadurch gekennzeichnet, dass** die PVD-Schicht (5) als PVD-Viellagenschicht, insbesondere auf Basis von AlTiN/CrN, oder als homogene Schicht, insbesondere auf Basis von CrN, CrN(O) oder CrN mit einem Sauerstoffgehalt bis zu 15 Gew.-%, ausgebildet ist, die im Temperaturbereich zwischen 100 und 200°C einen Wärmeausdehnungskoeffizienten < 4 x 10⁻⁶/K aufweist, wobei die Schichtdicke der PVD-Schicht (5) im Bereich des Kolbenringrückens zwischen 5 und < 40 µm und im stoßnahen Bereich (3,4) zwischen 40 und < 100 µm beträgt.

9. Kolbenring nach einem der Ansprüche 5 bis 8, **dadurch gekennzeichnet, dass** die PVD-Schicht (5) auf Basis von C ausgebildet ist, die im Temperaturbereich zwischen 100 und 200°C einen Wärmeausdehnungskoeffizienten < 2 x 10⁻⁶/K aufweist, wobei die Schichtdicke der PVD-Schicht (5) im Bereich des Kolbenringrückens zwischen > 1 und 20 µm und im stoßnahen Bereich (3,4) max. 30 µm beträgt.

10. Kolbenring nach einem der Ansprüche 5 bis 8, **dadurch gekennzeichnet, dass** die PVD-Schicht (5) Nanopartikel beinhaltet.

## Claims

1. A method for manufacturing a piston ring made of cast iron or cast steel, in that a piston ring base body (1) is produced which, seen over the circumference, is coated with at least one PVD layer (5) having a variable coating thickness, in such a manner that in the area of the bump ends (3, 4) a higher layer thickness is achieved with respect to the remaining circumferential area of the piston ring base body (1), **characterized in that** the piston ring base body (1) is worked such that in the non-motoric cold operating state it comprises a radial pressure distribution, in which the bump ends (3, 4) do almost not comprise any radial pressure over a defined circumferential angle, that a PVD layer (5) having an expansion coefficient of < 4 x 10⁻⁶/K will be applied onto a piston ring base body (1) having an expansion coefficient of < 15 x 10⁻⁶/K in the temperature range comprised between 100 and 200°C and that the variable layer thickness of the PVD layer (5) will be set such that the area close to the ends (3, 4) of the piston ring base body (1) will be provided with a layer thickness of the PVD layer of < 100 µm, especially < 60 µm, and the remaining circumferential area of the piston ring base body (1) will be provided with a layer thickness of the PVD layer of < 60 µm, especially < 40 µm, such that at a piston ring temperature of above 150°C a nearly uniform radial pressure distribution over the entire ring circumference of the piston ring will be obtained.

2. A method according to claim 1, **characterized in that** the PVD layer (5) will be applied as PVD multi-layer, in particular on the base of AlTiN/CrN, onto the bearing surface of the piston ring base body (1).

3. A method according to claim 1, **characterized in that** the PVD layer (5) will be applied as a homogenous layer on the base of CrN, CrN(O) or CrN having an oxygen content of up to 15 % by weight onto the bearing surface of the piston ring base body (1).

4. A method according to claim 1, **characterized in that** a C-based layer is used as PVD layer.

5. A piston ring manufactured according to the method according to one of the claims 1 through 4,
comprising a base body (1) made of cast steel or cast iron and provided with a slit (2), on the outer circumferential surface of which base body at least one wear-resistant PVD layer (5) is applied, **characterized in that** the piston ring base body (1) is made of steel material having a coefficient of thermal expansion of < 15 x 10⁻⁶/K in the temperature range comprised between 100 and 200°C, that the PVD layer (5) in the area of the bump ends (3, 4) of the piston ring base body (1), seen over a defined circumferential area, is thicker with respect to the material thickness thereof than in the remaining circumferential area, such that the layer thickness of the PVD layer (5) in the area of the bump ends (3, 4) is comprised between 40 and 100 µm and the layer thickness of the PVD layer (5) in the remaining circumferential area is comprised between 5 and 60 µm.

6. A piston ring according to claim 5, **characterized in that** the layer thickness of the PVD layer (5) in the area of the bump ends (3, 4) is thicker by 20 to 40 % than the one in the remaining circumferential area.

7. A piston ring according to one of the claims 5 or 6, **characterized in that** the area having the higher layer thickness of the PVD layer (5) extends over a circumferential area comprised between 10 and 40°, especially between 10 and 20°, starting from the slit (2) of the piston ring base body (1).

8. A piston ring according to one of the claims 6 through 7, **characterized in that** the PVD layer (5) is designed as PVD muli-layer, in particular on the base of AlTiN/CrN, or as a homogenous layer, in particular on the base of CrN, CrN(O) or CrN having an oxygen content of up to 15 % by weight, which comprises a coefficient of thermal expansion of < 4 x 10⁻⁶/K in the temperature range comprised between 100 and 200°C, wherein the layer thickness of the PVD layer (5) is comprised between 5 and < 40 µm in the area of the piston ring spine and between 40 and < 100 µm in the area of the bump ends (3, 4).

9. A piston ring according to one of the claims 5 through 8, **characterized in that** the PVD layer (5) is formed on the base of C, which layer comprises a coefficient of thermal expansion of < 2 x 10⁻⁶/K in the temperature range comprised between 100 and 200°C, wherein the layer thickness of the PVD layer (5) is comprised between > 1 and 20 µm in the area of the piston ring spine and is max. 30 µm in the area of the bump ends (3, 4).

10. A piston ring according to one of the claims 5 through 8, **characterized in that** the PVD layer (5) contains nanoparticles.

## Revendications

1. Procédé de fabrication d'un segment de piston en fonte ou en acier moulé, dans lequel un corps de base de segment de piston (1) est produit, qui, vu sur la circonférence, est revêtu d'au moins une couche PVD (5) ayant une épaisseur de couche variable, de sorte qu'une épaisseur de couche plus élevée est atteinte dans la région d'extrémités d'aboutement (3, 4) par rapport à celle de la région circonférentielle restante du corps de base de segment de piston (1), **caractérisé en ce que** le corps de base de segment de piston (1) est traité de sorte que dans l'état de fonctionnement non-motrice et froid il comprend une distribution de pression radiale, dans laquelle les extrémités d'aboutement (3, 4) ne comprennent presque aucune pression radiale sur un angle circonférentiel défini, qu'une couche PVD (5) ayant un coefficient de dilation de < 4 x 10⁻⁶/K est appliquée sur un corps de base de segment de piston (1) ayant un coefficient de dilatation de < 15 x 10⁻⁶/K dans la gamme de température comprise entre 100 et 200°C et que l'épaisseur de couche variable de la couche PVD (5) est réglée de sorte que la région d'extrémités d'aboutement (3, 4) du corps de base de segment de piston (1) est munie d'une épaisseur de couche de la couche PVD (5) de < 100 µm, notamment de < 60 µm, et la région circonférentielle restant du corps de base de segment de piston (1) est munie d'une épaisseur de couche de la couche PVD (5) de < 60 µm, notamment de < 40 µm, de sorte qu'une distribution de pression radiale presque uniforme est obtenue sur la circonférence annulaire entière du segment de piston à une température de segment de piston de plus de 150°C.

2. Procédé selon la revendication 1, **caractérisé en ce que** la couche PVD (5) est appliquée sous forme d'une multicouche, notamment sur la base de AlTiN/CrN, sur la surface de roulement du corps de base de segment de piston (1).

3. Procédé selon la revendication 1, **caractérisé en ce que** la couche PVD (5) est appliquée sous forme d'une couche homogène sur la base de CrN, de CrN(O) ou de CrN comprenant une teneur en oxygène de jusqu'à 15 % en poids sur la surface de roulement du corps de base de segment de piston (1).

4. Procédé selon la revendication 1, **caractérisé en ce qu'**une couche sur la base de C est utilisée comme couche PVD.

5. Segment de piston fabriqué selon le procédé selon l'une des revendications 1 à 4, comprenant un corps de base en fonte ou en acier moulé et muni d'une fente (2), au moins une couche PVD résistante à l'usure (5) étant appliquée sur la surface circonférentielle extérieure de celui-ci, **caractérisé en ce que** le corps de base de segment de piston (1) est fabriqué en un matériau d'acier comprenant un coefficient de dilatation de < 15 x 10⁻⁶/K dans la gamme de températures comprise entre 100 et 200°C, que, vu sur une zone circonférentielle définie, la couche PVD (5) est plus épaisse par rapport à son épaisseur de matériau dans la région d'extrémités d'aboutement (3, 4) du corps de base de segment de piston (1) que dans la région circonférentielle restante, de sorte que l'épaisseur de couche de la couche PVD (5) est comprise entre 40 et 100 µm dans la région d'extrémités d'aboutement (3, 4) et l'épaisseur de couche de la couche PVD (5) est comprise entre 5 et 60 µm dans la région circonférentielle restante.

6. Segment de piston selon la revendication 5, **caractérisé en ce que** l'épaisseur de couche de la couche PVD (5) dans la région d'extrémités d'aboutement (3, 4) est entre 20 et 40 % plus épaisse que celle dans la région circonférentielle restante.

7. Segment de piston selon l'une des revendications 5 ou 6, **caractérisé en ce que** la zone de l'épaisseur de couche plus élevée de la couche PVD (5) s'étend sur une région circonférentielle entre 10 et 40°, notamment entre 10 et 20°, à partir de la fente (2) du corps de base de segment de piston (1).

8. Segment de piston selon l'une des revendications 6 à 7, **caractérisé en ce que** la couche PVD (5) est configurée comme une multicouche PVD, notamment sur la base de CrN, de CrN(O) ou de CrN comprenant une teneur en oxygène de jusqu'à 15 % en poids et comprenant un coefficient de dilatation de < 4 x 10⁻⁶/K dans une gamme de températures comprise entre 100 et 200°C, l'épaisseur de la couche PVD (5) étant comprise entre 5 et < 40 µm dans la région du dos de segment de piston et entre 40 et < 100 µm dans la région d'extrémités d'aboutement (3, 4).

9. Segment de piston selon l'une des revendications 5 à 8, **caractérisé en ce que** la couche PVD (5) est formée sur la base de C et comprend un coefficient de dilatation de < 2 x 10⁻⁶/K dans une gamme de températures comprise entre 100 et 200°C, l'épaisseur de la couche PVD (5) étant comprise entre > 1 et 20 µm dans la région du dos de segment de piston et étant max. 30 µm dans la région d'extrémités d'aboutement (3, 4).

10. Segment de piston selon l'une des revendications 5 à 8, **caractérisé en ce que** la couche PVD (5) contient des nanoparticules.
